# EUROPÄISCHE PATENTSCHRIFT

(11) **EP 2 266 781 B1**
(45) Veröffentlichungstag und Bekanntmachung des Hinweises auf die Patenterteilung: **05.12.2012**
(21) Anmeldenummer: 10173716.1
(22) Anmeldetag: 09.05.2005
(51) Int. Cl.: B29C 67/00, G03F 7/20

(54) **Verfahren und Vorrichtung zur Herstellung eines dreidimensionalen Objekts mit Auflösungsverbesserung mittels Pixel-Shift**
Method and apparatus for creating a three dimensional object with resolution enhancement by means of pixel shift
Procédé et dispositif de fabrication d'un objet en trois dimensions à résolution améliorée par décalage de pixels

(30) Priorität: 10.05.2004 DE 102004022961; 10.05.2004 US 569893 P
(43) Veröffentlichungstag der Anmeldung: 29.12.2010
(62) Teilanmeldung aus: 07024525.3
(73) Patentinhaber: Envisiontec GmbH, 45968 Gladbeck (DE)
(72) Erfinder: Shkolnik, Alexandr, Los Angeles, CA 90046 (US); John, Hendrik, 46569, Hünxe (DE); El-Siblani, Ali, Dearborn Heights, MI 48127 (US)
(74) Vertreter: Viering, Jentschura & Partner

(56) Entgegenhaltungen:
- EP-A1- 0 958 912
- WO-A2-02/27408
- DE-A1- 19 929 199
- US-A- 6 029 096

## Beschreibung

### Anwendungsgebiet

Die Erfindung betrifft ein Verfahren und eine Vorrichtung zur Herstellung eines dreidimensionalen Objekts durch schichtweises Verfestigen eines photohärtenden Materials durch Maskenbelichtung mittels einer gerasterten bildgebenden Einheit mit konstanter Auflösung, wobei die Auflösung in der Bild-/Bauebene im Subpixelbereich verbessert werden soll.

### Stand der Technik

Für den schichtweisen Aufbau dreidimensionaler Objekte aus "lichthärtenden" Materialien werden in der Literatur unterschiedlichste Verfahren angegeben, siehe hierzu "Automated Fabrication - Improving Productivity in Manufacturing" von Marshall Burns, 1993 (ISBN 0-13-119462-3).

Diese Efindung betrifft Verfahren, bei denen die zu erzeugende Schicht durch die Belichtung mittels einer gerasterten Maske beruht, wobei die kleinste physikalische Auflösung in der Maske durch die Größe eines Pixels gegeben ist.

Derzeit bekannte Möglichkeiten sind u.a. die Belichtung durch
a) Projektionseinheit (auf Basis DLP^{®}/DMD^{®}, LCD, ILA^{®}, etc.)
b) LC-Display (reflexiv, transmissiv)
c) LED-, bzw. Laser-Dioden-Zeile/-Matrix (die in XY über die Schicht bewegt wird)
d) auf MEM's-Technologie (light-valve) basierende Zeile ode Matrix (die in XY über die Schicht bewegt wird)

Einige dieser Methoden werden in folgenden Patenten beschrieben:
IPC: B29C67/00 "Rapid Prototyping apparatus and method of Rapid Prototyping" von Dicon AS (DK), (Anmeldung)
US-Patent US005247180A "Stereolithographic Apparatus and Method of use" von Texas Instruments Inc., Sept. 1993.
US-Patent US005980813A "Rapid Prototyping using multiple materials" von SRI International, Nov. 1999;
Gebrauchsmusterschrift DE G 93 19 405.6 "Vorrichtung zur Herstellung eines dreidimensionalen Objekts (Modells) nach dem Prinzip der Photoverfestigung" vom Forschungszentrum Informatik an der Universität Karlsruhe, Dez. 1993;
eine Anwendung für die Erzeugung mikrotechnischer, dreidimensionaler Bauteile nach einem ähnlichen Verfahren wird in der Gebrauchsmusterschrift DE 299 11 122 U1 "Vorrichtung zum Herstellen eines dreidimensionalen Objektes", DeltaMed u.a., Juni 1999, beschrieben.
PCT-Patentanmeldung 02 008 019.8 "Vorrichtung zum Herstellen eines dreidimensionalen Objektes" der Envision Technologies GmbH, April 2002.

In der US 6,180,050 wird eine lineare Scan-Technik zur schichtweisen Verfestigung bei der Herstellung dreidimensionaler Bauteile beschrieben. Die Auflösung wird erhöht, indem ein Belichtungskopf mit einem Array von optischen Fasern, die in Y-Richtung gegeneinander versetzt sind, linear in X-Richtung gescannt werden.

In der US 6,029,096 wird ein Verfahren und eine Vorrichtung zur Identifizierung von Oberflächeneigenschaften von schichtweise hergestellten, dreidimensionalen Objekten vorgestellte

Die DE 199 29 199 A1 offenbart ein Verfahren gemäß dem Oberbegriff des Anspruchs 1 sowie eine Vorrichtung gemäß dem Oberbegriff des Anspruchs 9

### Nachteile Stand der Technik

Bei allen den oben beschriebenen Verfahren steht die Auflösung der zu härtenden Materialschicht in direkter Abhängigkeit mit der Auflösung des bildgebenden Verfahrens.

Bei den Projektionsverfahren bestimmt zusätzlich eine zwischengeschaltete Optik den Maßstab der projezierten, bzw. auszuhärtenden Schicht.

Die Auflösung pro Flächeneinheit in der Bild-/Bauebene ist somit abhängig a) von der Auflösung der bildgebenden Einheit bzw. dem kleinsten Element, genannt Pixel und deren relative Abstände zueinander, genannt Pixel-Pitch und b) dem Projektionsmaßstab.

Die Oberflächen-Rauhigkeit des Bauteils ist somit bestimmt durch die kleinste Volumeneinheit eines Voxels (Volumen-Pixels), dessen Größe sich zusammensetzt aus der der projizierten Pixelfläche in XY und der Schichtdicke in Z.

Die Auflösung der Schichtdicke ist vorgegeben durch die kleinste Auflösung (Schrittgröße) des Aktuators in Z um die Trägerplattform zu bewegen. Hier können bereits Auflösungen bis in den enstelligen µm-Bereich erreicht werden.

Soll eine niedrigere Oberflächen-Rauhigkeit des Bauteils erreicht werden, muss das Projektionsfeld und damit einhergehend die Pixelfläche verkleinert werden.

Als Beispiel sei hier die Projektion m.H. eines Multimedia-Projektors angegeben; bei einer Auflösung von XGA (1024 x 768 Bildpunkten), einem Pixel von 17µm und einem Pixel-Pitch von 17,9µm erreicht man bei einer Projektion auf 275mm x 206mm mit einem Vergrößerungsfaktor der Projektionsoptik von 15 eine Auflösung in der Bild-/Bauebene und somit der auszuhärtenden Schicht von annähernd 100dpi, was einer Pixelgröße in der Projektionsebene von rund 0,254 mm x 0,254 mm entspricht.

Um die Auflösung in der Bild-/Bauebene bei gleichbleibender Baufläche z.B. zu verdoppeln, wird bei den Projektionsverfahren vorgeschlagen, den Projektions-/Vergrößerungsfaktor zu halbieren (was eine Viertelung der Fläche bedeutet) und entweder die gesamte Projektionseinheit oder den Bauraum paralle zueinander zwecks Belichtung der vier Teilebenen zu verschieben.

Dieses Verfahren hat den erheblichen Nachteil, dass relativ große Massen sehr präzise zueinander bewegt werden müssen, um eine exaktes Aneinanderstoßen und eine innige Verbindung der Teilebenen zu gewährleisten, was für die dazu notwendige Mechanik einen erheblichen Kostenaufwand und zusätzlichen Platzbedarf in der gesamten Anordnung bedeutet.

Bei der selektiven direkten Belichtung durch das Abscannen m.H. einer LED-, bzw. Laser-Dioden-Zeile/-Matrix oder die direkte Belichtung durch eine Maske, die durch einen transmissiven LCD ausgebildet ist, ist die Auflösung in der Bauebene gleich der Auflösung in der bildgebenden Einheit.

### Aufgabe der Erfindung

Aufgabe der Erfindung ist es, ein Verfahren bzw. eine Vorrichtung bereitzustellen, die es ermöglicht, die Auflösung in der Bauebene bei gleich bleibend großer Baufläche um ein Vielfaches im Subpixelbereich zu erhöhen, d.h. die Rasterung der Außen- und Innenkonturen in den Schnittebenen des Objektes zu verfeinern,
a) ohne eine Belichtung in aneinandergesetzten Teilflächen vornehmen zu müssen und
b) ohne die Auflösung der gerasterten, bildgebenden Einheit selbst zu erhöhen.

### Lösung der Aufgabe

Diese Aufgabe wird durch ein Verfahren mit den Merkmalen nach Anspruch 1 bzw. durch eine Vorrichtung mit den Merkmalen nach Anspruch 9 gelöst. Bevorzugte Weiterbildungen des erfindungsgemäßen Verfahrens bzw. der erfindungsgemäßen Vorrichtung sind in den Unteransprüchen angegeben.

### Beschreibung der Erfindung und deren Vorteile

Durch das erfindungsgemäße Verfahren bzw. die erfindungsgemäße Vorrichtung wird die Auflösung in der Bild-/Bauebene im Subpixelbereich mittels "Pixel-Shift" verbessert. Insbesondere handelt es sich bei der Erfindung um ein schichtweises Verfestigen zur Herstellung dreidimensionaler Bauteile bzw. Körper durch Materialverfestigung (speziell durch Photopolymerisation) mittels Maskenprojektion, und nicht um eine herkömmliche schichtweise Verfestigung mittels (linearer) Scantechnik. Dies kann erfindungsgemäß sehr effektiv und vorteilhaft durch die Anwendung eines zweidimensional festgelegten Arrays als bildgebendem Element ausgeführt werden, bei dem Rasterung und/oder Auflösung fest vorgegeben ist/sind, z.B. durch ein fixes Mikrospiegel-Array.

Im Vergleich zur Scan-Technik, bei Canon als VAROS (Variable Refraction Optical System) und bei Epson als "Double-CCD" bezeichnet, wird das Prinzip, dem Einlesen und Überlagern von im Subpixel-Bereich zueinander versetzter Bilder, in dieser Efindung für gerasterte bildgebende Verfahren im Rapid Prototyping eingesetzt.

Die Auflösung bzw. die Anzahl der Bildpunkte der gerasterten, bildgebenden Einheit selbst muß nicht erhöht werden, um eine Verbesserung der Auflösung in der Bauebene zu erreichen.

Zur Erhöhung der Auflösung erfolgt die Belichtung nicht in nebeneinander angeordneten entsprechend verkleinerten Teilflächen, wodurch sich die Bau-/Belichtungszeit der Gesamtfläche um die Anzahl der Teilflächen erhöhen würde, sondern die Projektion/Belichtung erfolgt über die gesamte Baufläche.

Dadurch dass eine Überlagerung der im Subpixel-Bereich zueinander versetzten Bilder stattfindet erhöht sich die Bau-/Belichtungszeit der Gesamtfläche nur unwesentlich.

Der Grad der Auflösungsverbesserung in der Bauebene ist frei wählbar.

### Beschreibung der Zeichnungen und der bevorzugten Ausführungsformen der Erfindung

Die vorliegende Erfindung wird nachfolgend beispielhaft und nicht einschränkend anhand von Zeichnungen näher erläutert.

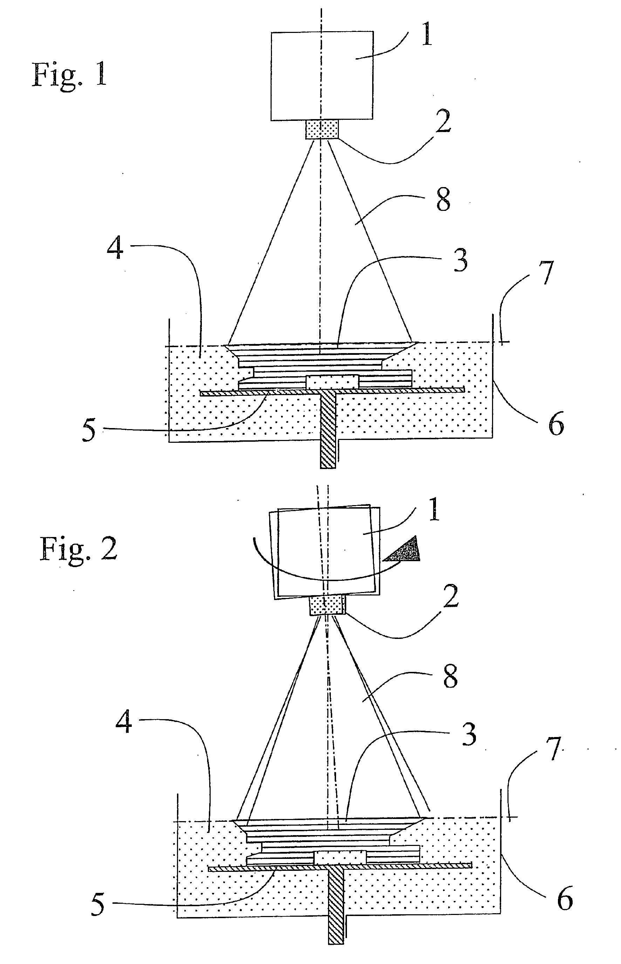

Fig. 1 zeigt schematisch eine grundsätzliche Vorrichtung zur Generierung eines dreidimensionalen Objekts 3 durch schichtweise Aushärtung eines photohärtenden Materials 4 mittels Maskenprojektion 8, wobei sich die Projektionseinheit 1 mit einer abbildenden Optik 2 oberhalb des Beckens 6, gefüllt mit photohärtendem Material 4, befindet und das Objekt 3 schichtweise auf einer Trägerplatte 5 aushärtet, die innerhalb des Beckens 6 in vertikaler Richtung bewegt werden kann.

Bei einem auf Photohärtung basierenden Verfahren mittels Maskenbelichtung wird die zum Härten notwendige Strahlung in die Bild-/Bauebene 7 projiziert. Die Belichtung wird mit Hilfe einer gerasterten bildgebenden Einheit ausgeführt, die als Matrix ausgebildet ist. Das Bild setzt sich dabei aus einzelnenen Bildpunkten (Pixeln) zusammen und bildet so eine gerasterte Maske (Bitmap), wobei die Pixel in der Ebene räumlich zueinander fest angeordnet sind.

Fig. 8 - 12 zeigen an einem einfachen Beispiel das Prinzip der Maskengenerierung (Bitmapping) einer Querschnittsfläche eines dreidimensionalen Objektes in der Ausgangspostion (Fig. 8) und in unterschiedlichen, im Subpixelbereich versetzten (geshifteten) Zuständen der Bitmap (Fig. 9 - 11), sowie die Überlagerung sämtlicher Bitmaps (Fig. 12).

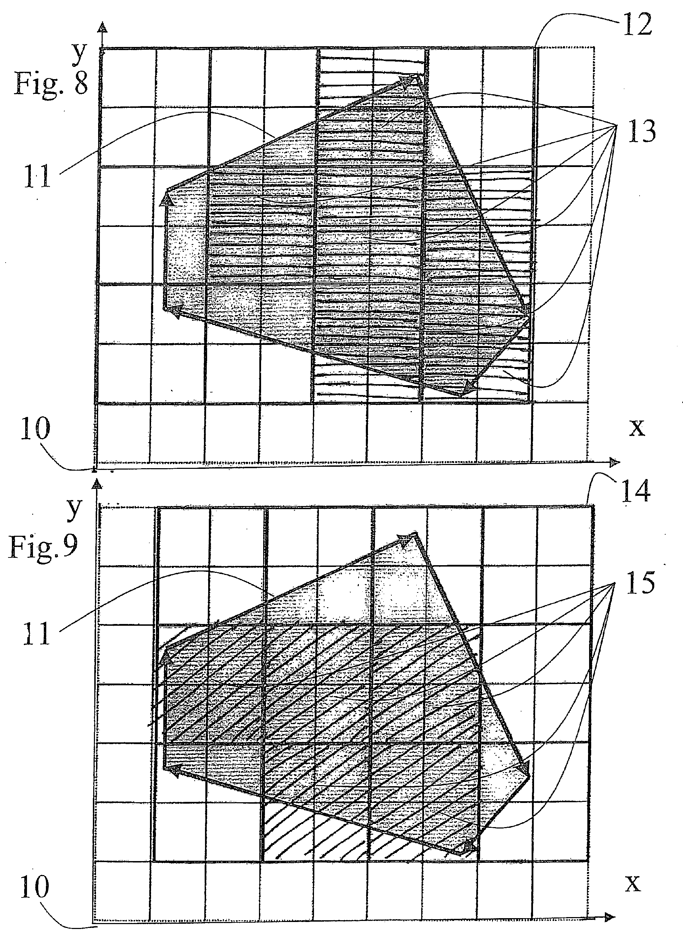

Die Querschnittsfläche, d.h. Außen- und Innenkonturen, wird durch einen Vektorzug 11 beschrieben, der von einer gerasterten Fläche (Bitmap) 12 überlagert wird, deren Auflösung exakt der Auflösung der diskreten Elemente (Pixel) im projizierten Bild 8 entspricht, welches durch die bildgebende Matrix erzeugt wird. Vektorzug 11 und Bitmap 12 befinden sich dabei in einem übergeordneten XY-Koordinatensystem 10. Fig. 8 zeigt die Bitmap in ihrer Ausgangsposition. Durch einen speziellen Algorithmus werden die aktiven Pixel 13 berechnet, die in der Bitmap 12 in der Ausgangsposition die Querschnittsfläche beschreiben.

In Fig. 9 wurde die Bitmap 14 relativ zur Querschnittsfläche um Delta X im Subpixelbereich versetzt, wodurch sich eine neue Verteilung der aktiven Pixel 15 ergibt.

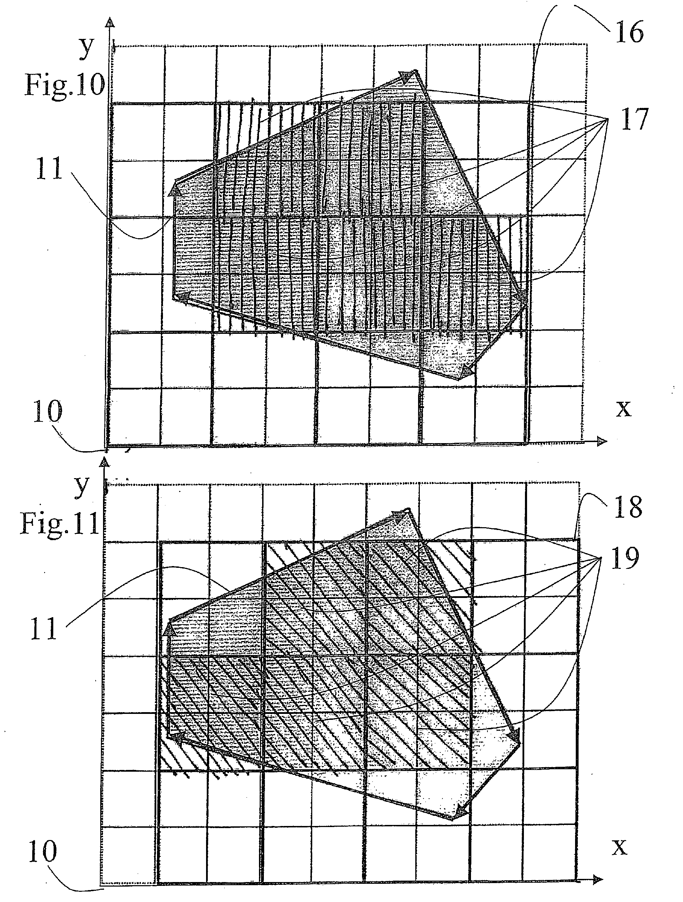

Fig. 10 zeigt einen Versatz der Bitmap 16 relativ zur Querschnittsfläche um Delta Y mit den aktiven Pixeln 17.

Fig. 11 zeigt einen Diagonal-Versatz der Bitmap 18 relativ zur Querschnittsfläche Delta X und Delta Y mit den aktiven Pixeln 19.

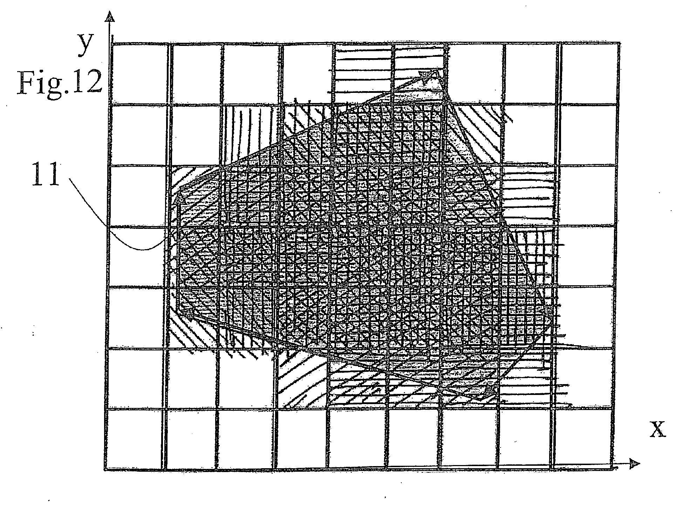

In Fig. 12 sind alle Bitmaps 12, 14, 16 und 18 mit ihren aktiven Pixeln 13, 15, 17 und 19 überlagert dargestellt, wobei eindeutig eine Auflösungsverbesserung im (Aussen-)Konturbereich der Querschnittsfläche zu erkennen ist.

Ein vereinfachtes Verfahren zur Auflösungsverbesserung wird dadurch erreicht, indem nur die Bitmap 12 der Ausgangsposition (Fig. 8) und die Bitmap 18 des Diagonal-Versatzes (Fig. 11) überlagert werden. In diesem Fall muss die Bitmap, bzw. das Bild nur in eine Richtung entlang der Pixel-Diagonalen geshiftet werden.

Je nach gewünschter Auflösungsverbesserung kann für jede Objektschicht ein Mehr- bzw. Vielfaches (mindestens zweifach) an Masken bzw. Bitmaps mit unterschiedlichem Subpixelversatz generiert und überlagert werden.

Durch eine unterschiedlich versetzte und überlagerte Belichtung jeder Objekt-/Materialschicht (hier mittels der Bitmaps 12, 14, 16, 18) wird eine Auflösungsverbesserung in XY im Bereich der Außen- und Innenkonturen erzielt. Um die jeweilige Subpixel-Verschiebung des Bildes in der Bauebene zu erreichen, werden im folgenden unterschiedliche Ausführungsformen beschrieben:
1) In Fig. 2 wird die bildgebende Einheit 1 je versetzter Bitmap so gekippt, dass die gewünschte Verschiebung des Bildes im Subpixelbereich in der Bild-/Bauebene erreicht wird.

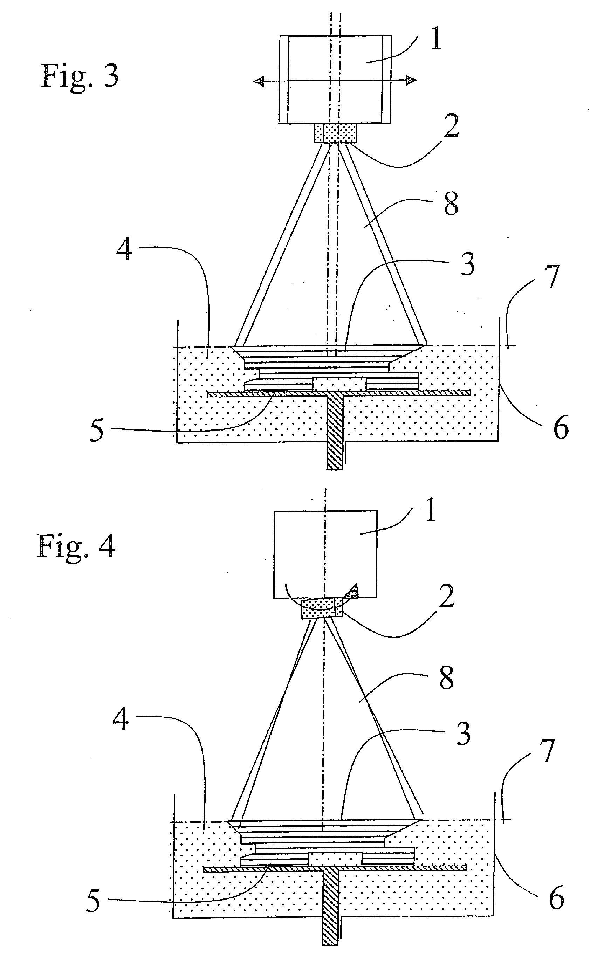

2) In Fig. 3 wird die bildgebende Einheit 1 je versetzter Bitmap um den entsprechenden Subpixelbereich in X und Y, also planparallel zur Bild-/Bauebene durch Aktuatoren versetzt.
3) In Fig. 4 bleibt die bildgebende Projektionseinheit in ihrer Position fest. Die abbildende Optik 2 wird je versetzter Bitmap so gekippt, dass die gewünschte Verschiebung des Bildes in der Bild-/Bauebene im Subpixelbereich erreicht wird.

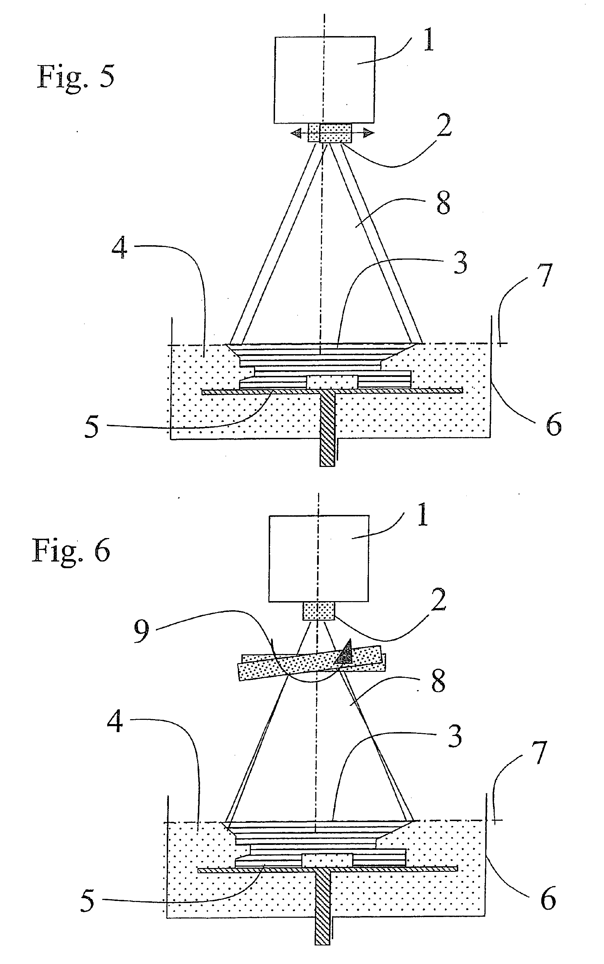

4) In Fig. 5 bleibt die bildgebende Projektionseinheit in ihrer Position fest. Die abbildende Optik 2 wird je versetzter Bitmap in XY so verschoben, dass die gewünschte Verschiebung des Bildes in der Bild-/Bauebene im Subpixelbereich erreicht wird.
5) Sonderfall für Abbildungen mit bildseitig telezentrischen Strahlengang, bildseitig annähernd telezentrischen Strahlengang und Teleobjektiven mit langer Brennweite, um die optischen Fehler (Winkelfehler, Verzeichnung) klein zu halten:
   a) In Fig. 5 wird die Projektionseinheit 1 je versetzter Bitmap über Aktuatoren so verkippt, dass das Projektionsbild 8 in der Bild-/Bauebene 7 im entsprechenden Subpixelbereich in X und Y versetzt wird.
   b) In Fig. 6 ist zwischen Projektionseinheit 1 und Bild-/Bauebene 7 eine kardanisch aufgehängte transparente planparallele Platte 9 (Glasplatte) angeordnet, die durch Rotation um zwei Achsen (XY), die sich planparallel zur Bild-/Bauebene befinden, den Projektionsstrahlengang 8 und somit das Bild in der Bild-/Bauebene 7 im Subpixelbereich in X und Y versetzt.

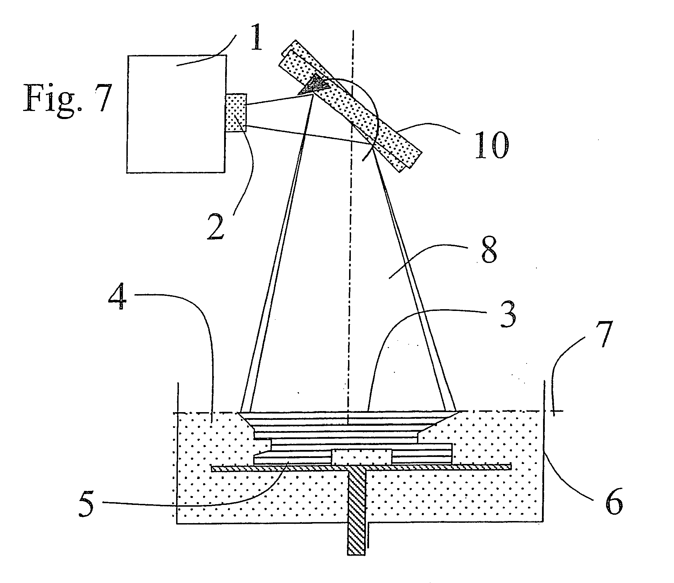

   c) In Fig. 7 bleibt die Projektionseinheit 1 in ihrer Position fest. Der Projektionsstrahl 8 wird über einen Spiegel 10 in die Bild-/Bauebene 7 umgelenkt. Der Umlenkspiegel 10 verfügt über eine Verstellmöglichkeit (kardanische Lagerung), durch die der Projektionsstrahl je versetzter Bitmap so abgelenkt werden kann, dass in der Bild-/Bauebene 7 eine Verschiebung des Bildes im Subpixelbereich erreicht wird.

Die oben beschriebenen Ausführungsformen 1) bis 5) bzw. a) bis c) können einzeln verwirklicht oder miteinander kombiniert werden.

Die für die Maskenprojektion notwendigen Bitmaps jeder einzelnen Schicht werden aus Schichtdaten erzeugt, in denen die Außen- und Innenkonturen des jeweiligen Objektquerschnitts in Vektorzügen dargestellt sind (wie z.B. im Datenformat CLI definiert).

Hierzu wird eine spezielle SW verwendet, welche die Umrechnung der Vektorgrafiken in das Bitmap-Format (Bitmapping) ausführt.

Für jeden Subpixelversatz in XY wird eine separate Bitmap erzeugt, indem die XY-Koordinaten der Vektoren (für Außen- und Innenkonturen) der Schichtdaten mit dem jeweiligen Versatz-Offset in XY (im Subpixelbereich) transformiert und über das Bitmap-Raster gelegt werden und so eine neue Verteilung der aktiven Pixel je Versatz errechnet wird.

Die projezierte Lichtleistung pro Pixel kann durch "Graustufen" innerhalb einer Projektionsmaske variiert werden, um so den Aushärtegrad selektiv in einer Schicht zu beeinflussen. Dies ist insbesondere sinnvoll, um Lichtleistung der Kontur-Pixel anzuheben, da sich hier aufgrund des Subpixelversatzes der einzelnen Bitmaps nur Teilüberlagerungen der jeweiligen Kontur-Pixel ergeben (in den Flächen innerhalb der Konturen ist eine vollständige Überlappung der Pixel der einzelnen Bitmaps gewährleistet).

Bei der Projektion / Überlagerung der um Subpixel versetzten Schichtbilder kann durch Überlagern von Graustufen insbesondere entlang der Konturen der projezierten Flächenstruktur eine nahezu homogene Verteilung der Lichtleistung bzw. der Belichtungsintensität über die Summe der Graustufenmasken erzielt werden.

## Patentansprüche

1. Verfahren zur Generierung einer Bitmap (12, 14, 16, 18) bezüglich einer Querschnittsfläche eines durch Verfestigen eines, unter Einwirkung von elektromagnetischer Strahlung verfestigbaren Materials mittels Maskenbelichtung über eine bildgebende Einheit herzustellenden dreidimensionalen Objektes (3), **dadurch gekennzeichnet, dass** die Querschnittsfläche, d.h. Außen- und Innenkonturen, durch Vektorzüge (11) beschrieben werden, die bildverarbeitungstechnisch einer gerasterten Fläche oder Bitmap (12, 14, 16, 18) überlagert werden, deren Auflösung exakt der Auflösung der diskreten Elemente oder Pixel in der bildgebenden Einheit entspricht, wobei die Überlagerung von Vektorzügen (11) und Bitmap (12, 14, 16, 18) in einem übergeordneten XY- Koordinatensystem (10) erfolgt und durch einen Algorithmus die aktiven Pixel (13, 15, 17, 19) berechnet werden, um die Querschnittsfläche in Form einer gerasterten Maske zu beschreiben,
wobei mittels Pixelshift die Auflösung verbessert wird. **dadurch gekennzeichnet, dass**

2. Verfahren nach Anspruch 1, **dadurch gekennzeichnet, dass** die Maskengenerierung oder das Bitmapping einer jeden Querschnittsfläche eines herzustellenden dreidimensionalen Objektes (3) in der Ausgangsposition und in unterschiedlichen, in XY versetzten oder geshifteten Zuständen erfolgt und durch Überlagerung dieser Bitmaps (12, 14, 16, 18) pro Querschnittsfläche ein Gesamtbild mit entsprechend dem Pixelshift erhöhter Auflösung im Konturbereich entsteht.

3. Verfahren nach einem der Ansprüche 1 oder 2, **dadurch gekennzeichnet, dass** eine Bitmap (12, 14, 16, 18) erzeugt wird, die relativ zur Querschnittsfläche um Delta X und/oder um Delta Y im Subpixelbereich versetzt ist, wodurch sich eine neue Verteilung der aktiven Pixel (13, 15, 17, 19) ergibt.

4. Verfahren nach einem der vorangehenden Ansprüche, **dadurch gekennzeichnet, dass** sich die Gesamtbelichtung pro Querschnittsfläche aus der Summe von Teilbelichtungen von im Subpixelbereich versetzten Masken oder Bitmaps (12, 14, 16, 18) ergibt.

5. Verfahren nach einem der vorangehenden Ansprüche, wobei je nach gewünschter Auflösungsverbesserung für jede Querschnittsfläche ein Vielfaches an Masken oder Bitmaps (12, 14, 16, 18) mit unterschiedlichem Pixelversatz in XY generiert wird, und wobei mit dem Vielfachen an Masken oder Bitmaps (12, 14, 16, 18) pro Querschnittsfläche seriell belichtet wird.

6. Verfahren nach einem der vorangehenden Ansprüche, **dadurch gekennzeichnet, dass** ein vereinfachtes Verfahren zur Auflösungsverbesserung erreicht wird, indem nur die Bitmap der Ausgangsposition (12) und die Bitmap eines Diagonal-Versatzes (18) entlang der Pixel-Diagonalen erzeugt und pro Querschnittsfläche nacheinander belichtet werden.

7. Verfahren nach Anspruch 6, **dadurch gekennzeichnet, daß** Bitmap des Diagonal-Versatzes (18) um eine halbe Pixel-Diagonale versetzt erzeugt wird.

8. Verfahren nach einem der vorangehenden Ansprüche, wobei pro Querschnittsfläche eine Mehrzahl von zueinander im Subpixelbereich versetzten Bildern in der Bild- oder Bauebene (7) gebildet werden, wobei für jedes versetzte Bild eine separate Maske oder Bitmap (12, 14, 16, 18) erzeugt wird.

9. Vorrichtung zur Herstellung eines dreidimensionalen Objektes (3) durch Verfestigen eines, unter Einwirkung von elektromagnetischer Strahlung verfestigbaren Materials mittels Maskenbelichtung, wobei die zum Härten notwendige Strahlung in eine Bild- oder Bauebene (7) abgebildet wird, wobei die Vorrichtung eine gerasterte bildgebende Einheit zur selektiven Belichtung, die entweder als Zeile oder Matrix ausgebildet ist, aufweist,
wobei die bildgebende Einheit das Bild aus einzelnen Bildpunkten oder Pixeln zusammensetzt und so eine gerasterte Maske oder Bitmap (12, 14, 16, 18) bildet, wobei die Pixel in der Ebene räumlich zueinander fest angeordnet sind, **dadurch gekennzeichnet, dass**
die Vorrichtung darauf angepaßt ist, daß eine Querschnittsfläche, d.h. Außen- und Innenkonturen des dreidimensionalen Objekts (3) durch Vektorzüge (11) beschrieben wird, die bildverarbeitungstechnisch einer gerasterten Fläche oder Bitmap (12, 14, 16, 18) überlagert werden, deren Auflösung exakt der Auflösung der diskreten Elemente oder Pixel in der bildgebenden Einheit entspricht, wobei die Überlagerung von Vektorzügen (11) und Bitmap (12, 14, 16, 18) in einem übergeordneten XY- Koordinatensystem (10) erfolgt und durch einen Algorithmus die aktiven Pixel (13, 15, 17, 19) berechnet werden, um die Querschnittsfläche in Form einer gerasterten Maske zu beschreiben, wobei die Vorrichtung darauf angepasst ist, dass mittels Pixelshift die Auflösung verbessert ist.

10. Vorrichtung zur Herstellung eines dreidimensionalen Objektes (3) gemäß Anspruch 9, wobei die bildgebende Einheit und/oder eine zwischen bildgebender Einheit und der Bild- oder Bauebene vorgesehene, abbildende Optik so ausgestaltet ist/sind, dass eine Abfolge einer Mehrzahl von zueinander im Pixelbereich versetzten Bildern in der Bild- oder Bauebene (7) darstellbar ist,
wobei für jeden Pixelversatz in XY eine separate Bitmap (12, 14, 16, 18) erzeugbar ist, indem die XY-Koordinaten der Vektoren mit dem jeweiligen Versatz-Offset in XY transformiert und über das Bitmap-Raster gelegt werden und so eine neue Verteilung der aktiven Pixel (13, 15, 17, 19) je Versatz errechnet wird.

## Claims

1. Method for the generation of a bitmap (12, 14, 16, 18) regarding a cross-sectional area of a three-dimensional object (3) which is to be produced by solidifying a material that is solidifiable under the influence of electromagnetic radiation by means of mask exposure using an image-forming unit, **characterized in that** the cross-sectional area, which means outer and inner contours, are described by vector combinations (11) which, in terms of image processing, are overlaid on a rastered area or bitmap (12, 14, 16, 18) whose resolution corresponds exactly to the resolution of discrete elements or pixels in the image-forming unit, wherein the overlay of vector combinations (11) and bitmap (12, 14, 16, 18) occurs in a superordinate XY coordinate system (10) and the active pixels (13, 15, 17, 19) are calculated by an algorithm in order to describe the cross-sectional area in terms of a rastered mask, wherein the resolution is enhanced by means of pixel shift.

2. Method according to claim 1, **characterized in that** the mask generation or bitmapping of every cross-sectional area of a three-dimensional object (3) to be produced occurs in the starting position and in different states that are offset in XY or shifted and overlaying these bitmaps (12, 14, 16, 18) per cross-sectional area results in an overall image with an enhanced resolution, corresponding to the pixel shift, in the contour area.

3. Method according to one of claims 1 or 2, **characterized in that** a bitmap (12, 14, 16, 18) is created, which is offset relative to the cross-sectional area by delta X and/or by delta Y in the sub-pixel range, resulting in a new distribution of active pixels (13, 15, 17, 19).

4. Method according to one of the preceding claims, **characterized in that** the total exposure per cross-sectional area is a result of the sum of partial exposures of masks or bitmaps offset in the sub-pixel range (12, 14, 16, 18).

5. Method according to one of the preceding claims, wherein, depending on the desired resolution enhancement, multiple masks or bitmaps (12, 14, 16, 18) with different pixel shifts in XY are generated for every cross-sectional area, and wherein serial exposure with the multiple of masks or bitmaps (12, 14, 16, 18) per cross-sectional area is conducted.

6. Method according to one of the preceding claims, **characterized in that** a simplified process for resolution enhancement is achieved by creating only the bitmap of the starting position (12) and the bitmap of a diagonal offset (₁8) along the pixel diagonal and exposing them successively per cross-sectional area.

7. Method according to claim 6, **characterized in that** the bitmap of the diagonal shift (18) is created being offset by half a pixel diagonal.

8. Method according to one of the preceding claims, wherein a plurality of images offset from each other in the sub-pixel range is formed per cross-sectional area in the image- or construction plane (7), wherein a separate mask or bitmap (12, 14, 16, 18) is created for every offset image.

9. Device for the production of a three-dimensional object (3), via solidification of a material that is solidifiable under the influence of electromagnetic radiation, by means of mask exposure, wherein the radiation necessary for solidification is imaged onto an image- or construction plane (7), wherein the device comprises a rastered image-forming unit for selective exposure, which is formed either as a line or as a matrix, wherein the image-forming unit composes the image from single picture points or pixels, and thus forms a rastered mask or bitmap (12, 14, 16, 18), wherein the pixels are spatially, with respect to each other, arranged fixedly in the plane, **characterized in that** the device is adapted to describing a cross-sectional area, that is outer and inner contours of the three-dimensional object (3), by vector combinations (11) which, in terms of image processing, are overlaid on a rastered area or bitmap (12, 14, 16, 18) whose resolution corresponds exactly to the resolution of the discrete elements or pixels in the image-forming unit, wherein the overlay of vector combinations (11) and bitmap (12, 14, 16, 18) occurs in a superordinate XY coordinate system (10) and the active pixels (13, 15, 17, 19) are calculated by an algorithm in order to describe the cross-sectional area in the form of a rastered mask, wherein the device is configured to enhance resolution by means of pixel shift.

10. Device for the production of a three-dimensional object (3) according to claim 9, wherein the image-forming unit and/or an imaging optics provided between image-forming unit and image- or construction plane is configured in such a manner that a sequence of a plurality of images offset with respect to each other in the pixel area can be presented in the image- or construction plane (7), wherein a separate bitmap (12, 14, 16, 18) is producible for every pixel shift in XY, by transforming the XY coordinates of the vectors with the respective shift offset in XY and overlaying them to the bitmap raster and thus calculating a new distribution of active pixels (13, 15, 17, 19) per shift.

## Revendications

1. Procédé de création d'une table de bits (12, 14, 16, 18) relatif à une surface transversale d'un objet tridimensionnel (3) devant être fabriqué via une unité de fourniture d'image par la consolidation d'un matériau consolidable sous l'effet d'un rayonnement électromagnétique, au moyen d'une exposition avec un masque, **caractérisé en ce que** la surface transversale, c'est-à-dire les contours extérieurs et intérieurs, sont écrits par des tracés vectoriels (11) qui sont superposés par une technique de traitement d'image à une surface ou à une table de bits (12, 14, 16, 18) tramées, dont la résolution correspond exactement à la résolution des éléments discrets ou pixels dans l'unité de fourniture d'image, dans lequel la superposition des tracés vectoriels (11) et de la table de bits (12, 14, 16, 18) est réalisée dans un système de coordonnées XY (10) hiérarchiquement supérieur et les pixels actifs (13, 15, 17, 19) sont calculés via un algorithme afin d'écrire sur la surface transversale sous la forme d'un masque de trame, dans lequel la résolution est améliorée au moyen d'un déplacement de pixels.

2. Procédé selon la revendication 1, **caractérisé en ce que** la création du masque ou la formation de la table de bits d'une surface transversale respective d'un objet tridimensionnel (3) devant être fabriqué est réalisée dans la position de départ et dans différentes conditions décalées ou déplacées dans les coordonnées XY, et **en ce qu'**une image globale avec une résolution accrue correspondant au déplacement de pixels dans la zone des contours apparaît via la superposition de ces tables de bits (12, 14, 16, 18) pour chaque surface transversale.

3. Procédé selon l'une quelconque des revendications 1 ou 2, **caractérisé en ce qu'**est produite une table de bits (12, 14, 16, 18) qui est décalée d'un delta X et/ou d'un delta Y par rapport à la surface transversale et vers le sous-domaine de pixels, de sorte qu'une nouvelle répartition des pixels actifs (13, 15, 17, 19) est obtenue.

4. Procédé selon l'une quelconque des revendications précédentes, **caractérisé en ce que** l'exposition globale pour chaque surface transversale résulte de la somme d'expositions partielles de masques ou de tables de bits (12, 14, 16, 18) décalés dans le sous-domaine de pixels.

5. Procédé selon l'une quelconque des revendications précédentes, dans lequel en fonction de l'amélioration souhaitée de la résolution, une multiplicité de masques ou de tables de bits (12, 14, 16, 18) avec un décalage des pixels différent dans leurs coordonnées XY est créé pour chaque surface transversale, et dans lequel on expose en série avec la multiplicité de masques ou de tables de bits (12, 14, 16, 18) pour chaque surface transversale.

6. Procédé selon l'une quelconque des revendications précédentes, **caractérisé en ce qu'**un procédé simplifié pour l'amélioration de la résolution est obtenu **en ce que** seules la table de bits de la position de départ (12) et la table de bits d'un décalage diagonal (18) le long de la diagonale des pixels sont produites et exposées l'une après l'autre pour chaque surface transversale.

7. Procédé selon la revendication 6, **caractérisé en ce que** la table de bits du décalage diagonal (18) est produite avec un décalage d'une demi-diagonale de pixels.

8. Procédé selon l'une quelconque des revendications précédentes, dans lequel une pluralité d'images décalées les unes par rapport aux autres dans le sous-domaine de pixels sont formées dans le plan de l'image ou de la construction (7) pour chaque surface transversale, dans lequel un masque ou une table de bits (12, 14, 16, 18) distincts est produit(e) pour chaque image décalée.

9. Dispositif de fabrication d'un objet tridimensionnel (3) via la consolidation d'un matériau consolidable sous l'effet d'un rayonnement électromagnétique, au moyen d'une exposition avec un masque, dans lequel le rayonnement nécessaire au durcissement est représenté dans un plan d'image ou de construction (7), dans lequel le dispositif présente une unité de fourniture d'image de trame en vue de l'exposition sélective qui est conçue soit sous forme de lignes soit sous forme de matrice,
dans lequel l'unité de fourniture d'image compose l'image à partir de points d'image individuels ou de pixels et forme ainsi un masque ou une table de bits (12, 14, 16, 18) tramées, les pixels étant agencés de manière fixe les uns par rapport aux autres dans le plan,
**caractérisé en ce que** le dispositif est adapté pour qu'une surface transversale, c'est-à-dire les contours extérieurs et intérieurs de l'objet tridimensionnel (3), soit écrite par des tracés vectoriels (11) qui sont superposés par une technique de traitement d'image à une surface ou à une table de bits (12, 14, 16, 18) tramées, dont la résolution correspond exactement à la résolution des éléments discrets ou pixels dans l'unité de fourniture d'image, dans lequel la superposition des tracés vectoriels (11) et de la table de bits (12, 14, 16, 18) est réalisée dans un système de coordonnées XY (10) hiérarchiquement supérieur et les pixels actifs (13, 15, 17, 19) sont calculés via un algorithme afin d_{'}écrire sur la surface transversale sous la forme d'un masque de trame, dans lequel le dispositif est adapté pour que la résolution soit améliorée au moyen d'un déplacement de pixels.

10. Dispositif de fabrication d'un objet tridimensionnel (3) selon la revendication 9, dans lequel l'unité de fourniture d'image et/ou une optique de représentation d'image prévue entre l'unité de fourniture d'image et le plan de l'image ou de la construction est/sont réalisée(s) de telle sorte qu'une succession d'une pluralité d'images décalées les unes par rapport aux autres dans le domaine des pixels peut être représentée dans le plan de l'image ou de la construction (7), dans lequel une table de bits distincte (12, 14, 16, 18) peut être produite pour chaque décalage des pixels dans leurs coordonnées XY dans la mesure où les coordonnées XY des vecteurs sont transformées avec le degré de décalage respectif dans leurs coordonnées XY et déposées via la trame de table de bits et ainsi une nouvelle répartition des pixels actifs (13, 15, 17, 19) est calculée pour chaque décalage.
